## Europäisches Patentamt

## European Patent Office

## Office européen des brevets

(19)

(11) Veröffentlichungsnummer: **0 010 596**
**B1**

(12) ## EUROPÄISCHE PATENTSCHRIFT

(45) Veröffentlichungstag der Patentschrift:
09.02.83

(51) Int. Cl.³: **H 01 L 21/306**

(21) Anmeldenummer: 79103351.7

(22) Anmeldetag: 07.09.79

(54) Verfahren zur Ausbildung von Maskenöffnungen bei der Herstellung von Halbleiteranordnungen.

(30) Priorität: 03.11.78 US 957604

(43) Veröffentlichungstag der Anmeldung:
14.05.80 Patentblatt 80/10

(45) Bekanntmachung des Hinweises auf die Patenterteilung:
09.02.83 Patentblatt 83/6

(84) Benannte Vertragsstaaten:
AT BE CH DE FR GB NL SE

(56) Entgegenhaltungen:
DE-B-2 238 450
US-A-3 755 001
SOLID-STATE TECHNOLOGY, Band 19, Nr. 4, April 1976 Washington G. GLÖERSEN »Masking for ion beam etching« Seiten 68 bis 73.
SOLID-STATE TECHNOLOGY, Band 19, Nr. 5, Mai 1976 R. L. BERSIN »A survey of plasma etching processes« Seiten 31 bis 36.

(73) Patentinhaber: International Business Machines Corporation, Armonk, N.Y. 10504 (US)

(72) Erfinder: Pogge, Hans Bernhard, Road No. 3, LaDue Road, Hopewell Junction New York 12533 (US)

(74) Vertreter: Kreidler, Eva-Maria, Dr. rer. nat., Schönaicher Strasse 220, D-7030 Böblingen (DE)

## Verfahren zur Ausbildung von Maskenöffnungen bei der Herstellung von Halbleiteranordnungen

Die Erfindung bezieht sich auf ein Verfahren zur Herstellung einer Halbleiteranordnung, bei dem mindestens eine Maskenöffnung auf der Oberfläche eines die Halbleiteranordnung enthaltenden Körpers ausgebildet wird.

Die Komplexität integrierter Silicium-Schaltkreise hat in den letzten zehn Jahren erheblich zugenommen. Mit zunehmender Erschließung von Anwendungsgebieten für Mikroprozessoren und Kleinrechner ergab sich ein entsprechend zunehmendes Bedürfnis für eine gesteigerte Komplexität, höhere Schaltgeschwindigkeit und kleinere Abmessungen solcher integrierter Schaltkreise. Im Rahmen der Halbleiterprozesse erlaubt in erster Linie die Lithographie eine Steigerung der Komplexität der integrierten Schaltkreise. In den letzten Jahren konnten lediglich mäßige Verringerungen der erzielbaren (minimalen) Linienbreite integrierter Strukturen erreicht werden. Die hohen Steigerungen der Integrationsdichte wurden in erster Linie durch eine Senkung der photolithographischen Defektdichten erzielt. Dabei erfolgte eine allmähliche Verringerung der Linienbreiten von etwa 5 bis 10 µm auf heute etwa 3 bis 5 µm. Nahezu ausschließlich wurde ferner bisher Licht im Rahmen der Lithographierprozesse eingesetzt. Inzwischen machen jedoch die Grenzen der optischen Auflösung weitere Fortschritte zunehmend schwieriger. Für die zukünftig erforderlichen gesteigerten Packungsdichten setzt man daher heute zunehmend auf eine Lithographietechnik, die ohne Lichtstrahlung auskommt, insbesondere auf Elektronen- und Röntgenstrahlbelichtungsverfahren. Probleme dieser Art und mögliche Lösungen dafür werden eingehender behandelt in dem Artikel von B. L. Critchlow mit dem Titel »High Speed MOSFET Circuits Using Advanced Lithography«, veröffentlicht in der Zeitschrift Computer, Band 9, Nr. 2, Februar 1976, Seiten 31 bis 37. In diesem Artikel kommen insbesondere die erheblichen Kosten für die erforderliche Apparatur sowie die Komplexität der Röntgen- und Elektronenstrahllithographie zum Ausdruck. Bisher besteht jedoch die Auffassung, daß diese Techniken die einzigen Alternativen für die optische Projektionsbelichtung für derart hochkomplexe integrierte Schaltkreise der zukünftig benötigten Art darstellen.

Darüber hinaus gab es weitere Bemühungen, sehr schmale Linienbreiten im Bereich von 1 µm oder darunter durch Ausweitung der standardmäßigen photolithographischen Verfahren unter Vermeidung derart kostenträchtiger und komplexer Techniken wie Elektronen- oder Röntgenstrahllithographie zu erzielen. Ein möglicher Lösungsweg ist beispielsweise in der Veröffentlichung im IBM Technical Disclosure Bulletin, Vol. 19, No. 6, November 1976, Seiten 2057/2058 unter dem Titel »Narrow Line Widths Masking Method« beschrieben. Das dort behandelte Verfahren macht von porösem Silicium und einem zugehörigen Oxidationsprozeß Gebrauch. Ein anderes Verfahren ist in der Veröffentlichung im IBM Technical Disclosure Bulletin Vol. 20, No. 4, September 1977 auf den Seiten 1376 bis 1378 beschrieben. Dort werden polykristalline Maskierungsschichten aus Silicium benutzt, wobei die Maskenausbildung unter Einsatz einer Zwischenmaskierung aus einem oxidationshemmenden Material, z. B. im Fall von polykristallinem Silicium aus Siliciumnitrid, erfolgt. Mit diesem Verfahren lassen sich Linienbreiten unterhalb 2 µm erzielen.

Ferner steht in der Technik des Plasma- oder reaktiven Ionenätzens eine zum Ätzen von Metallen, halbleitenden und dielektrischen Materialien für integrierte Schaltkreise entwickelte Technik mit guten Eigenschaften zur Verfügung. Insbesondere läßt sich mit dem reaktiven Ionenätzen ein anisotropes Ätzen durchführen, mit dem hohe sog. Aspektverhältnisse erzielbar sind, d. h. die Ätzrate in vertikaler Richtung ist erheblich stärker ausgeprägt als die in horizontaler Richtung. Für die Prozeßdurchführung wird ein Plasma bzw. ionisiertes Gas benötigt, für das eine Vielzahl von hoch-reaktiven Bestandteilen, z. B. Ionen, freie Elektronen und freie Radikale, maßgeblich sind. Das zum ätzen eingesetzte Plasma kann auf relativ niedrigen Temperaturen in der Größenordnung bis etwa 250°C und bei geringen Drucken im Bereich von 0,006 bis 27 mbar gehalten werden. Die Plasma-Bestandteile sind überwiegend freie Radikale, die die intensive Reaktivität des Plasmas bewirken. Die Ionenbesetzung in einem Plasma von niedriger Temperatur beträgt größenordnungsmäßig etwa 1% der Bestandteile. In dem Artikel »A Survey of Plasma-Etching Processes«, von Richard L. Bersin, veröffentlicht in der Zeitschrift Solid State Technology, Mai 1976, Seiten 31 bis 36 ist sehr eingehend das Plasmaätzen sowie dessen Anwendung auf halbleitende Materialien behandelt. Ein solcher Prozeß wurde auch bereits eingesetzt, um Gräben oder Öffnungen in Silicium-Halbleiterkörpern auszubilden, vgl. z. B. die US-Patentschriften 3 966 577 (A. K. Hochberg), 4 104 086 (J. A. Bondur) sowie 4 139 442 (J. A. Bondur u. a.). Weitere Einzelheiten über die Technologie des reaktiven Ionenätzens bzw. Plasmaätzens können der DE-Offenlegungsschrift 2 617 483 (J. N. Harvilchuck u. a.) entnommen werden. Das von Harvilchuck angegebene HF-induzierte Plasma benutzt als Bestandteil reaktives Chlor, Brom oder Jod. In der zuletzt genannten Schrift findet sich auch eine nähere Beschreibung der HF-Entladekammer zur Durchführung des Verfahrens sowie der einzelnen Prozeßbedingungen:

Aus der DE-B-2 238 450 ist es bei der Herstellung von Isolationsgräben bekannt, in einem eine Halbleiteranordnung aufweisenden Körper Ausnehmungen mit im wesentlichen horizontalen und vertikalen Oberflächen herzustellen, auf die eine Isolierschicht aufgebracht wird, die anschließend derart geätzt wird, daß sie von den horizontalen Oberflächen der Ausnehmungen vollständig entfernt wird, worauf durch die derart freigelegte Öffnung mittels Diffusion ein Dotierungsgebiet in den Körper eingebracht wird.

Die Erfindung, wie sie in den Ansprüchen gekennzeichnet ist, löst die Aufgabe, den Anwendungsbereich konventionell ausgestatteter Lithographieverfahren bei der Herstellung von Maskenöffnungen zu weiter verringerten Öffnungsweiten im Bereich <1 μm auszuweiten, d. h. einen Weg anzugeben, mit dem auf der Grundlage konventioneller lithographischer Verfahren die damit heute möglichen Minimalabmessungen von Maskenöffnungen noch weiter in den genannten Bereich hin verringert werden können.

Mit den Maßnahmen der Erfindung lassen sich solche extrem schmal dimensionierten Maskenöffnungen ausbilden, die gegenüber mit üblichen Photolithographieverfahren herstellbaren Minimaldimension weiter verringerte Abmessungen aufweisen. Dazu werden zusammengefaßt in einem Körper 10 zunächst in üblicher Weise vorgegebene Öffnungsweiten aufweisende Ausnehmungen mit im wesentlichen horizontalen (14) sowie im wesentlichen vertikalen (16) Oberflächen hergestellt. Diese Anordnung wird anschließend mit einer die gesamte Oberfläche bedeckenden Maskierungsschicht (18) überzogen. Diese Schicht wird schließlich einem reaktiven Ionenätzverfahren unterworfen, bei dem die Maskierungsschicht von den horizontalen Oberflächen der Ausnehmungen abgetragen wird, und die auf den vertikalen Oberflächen der Ausnehmungen verbleibenden Bereiche der Maskierungsschicht zur Definition einer Maskenöffnung mit gegenüber der ursprünglichen Ausnehmung geringerer Öffnungsweite belassen werden. Das Verfahren läßt sich für zahlreiche in der Halbleitertechnik übliche Substrate bzw. Unterlagen einsetzen, z. B. für einkristalline Siliciumsubstrate mit oder ohne Epitaxieschichten oder Subkollektorbereiche, für von einer Schicht aus polykristallinem Silicium bedeckte Substrate mit einer isolierenden Einfach- oder Doppelschicht dazwischen oder dergleichen.

Die Erfindung wird im folgenden anhand von Ausführungsbeispielen unter Zuhilfenahme der Zeichnungen näher erläutert.

Es zeigen

Fig. 1A bis 1C den grundsäztlichen Verfahrensablauf nach der Erfindung,

Fig. 2A bis 2E die Darstellung eines Verfahrensablaufs zur Herstellung einer lithographischen Linienbreite <1 μm unter Anwendung der Erfindung,

Fig. 3A bis 3D die Ausbildung einer Diffusionsmaske mit lithographischen Abmessungen <1 μm im Rahmen einer weiteren Ausgestaltung der Erfindung;

Fig. 4A bis 4F den Ablauf eines Verfahrens zur Bildung einer Maskierung für eine Diffusion in Vertiefungsbereichen bzw. Gräben gemäß einem weiteren Ausführungsbeispiel der Erfindung,

Fig. 5A bis 5F ein weiteres Ausführungsbeispiel für den Herstellungsprozeß im Rahmen der Erfindung, wobei ein Substratanschluß mittels polykristallinem Silicium hergestellt wird und

Fig. 6A bis 6G ein weiteres Ausführungsbeispiel der Erfindung, in dem eine dielektrische Isolation sowie ein Substratkontakt im Rahmen der Herstellung einer bipolaren integrierten Transistorstruktur gebildet werden.

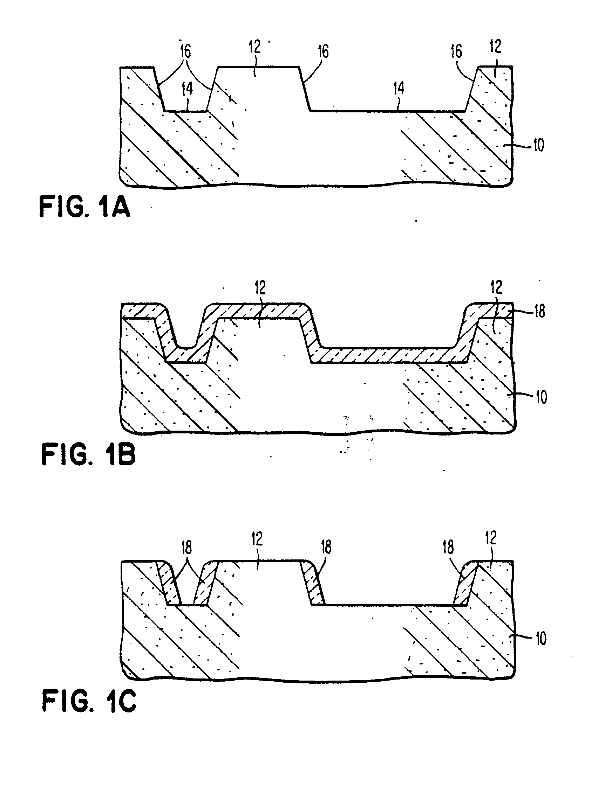

Anhand der Fig. 1A–1C soll zunächst auf die grundsätzlichen Verfahrensschritte im Rahmen einer Grundausführung der Erfindung eingegangen werden. Fig. 1A zeigt in starker Vergrößerung einen kleinen Ausschnitt aus einem Siliciumkörper, der zur Herstellung einer sehr hoch integrierten Schaltung dienen soll. Dazu wird von einem mit 10 bezeichneten Siliciumkörper ausgegangen, in dem mit 12 bezeichnete Bereiche gebildet sind, die im wesentlichen horizontale Oberflächenbereiche 14 sowie im wesentlichen vertikale Oberflächenbereiche 16 im Halbleiterkörper 10 zur Folge haben. Die Bereiche mit den horizontalen und vertikalen Oberflächen können alternativ durch Ätzen von Vertiefungen bzw. Gräben direkt in Siliciumkörper 10 hergestellt werden, oder man kann auf die Oberfläche des Siliciumkörpers eine Schicht aus isolierendem Material, aus polykristallinem Silicium oder dergleichen aufbringen und in dieser Schicht Öffnungen bis hinunter zum Siliciumkörper herstellen. Die mit 16 bezeichneten Oberflächenbereiche sollen dabei im wesentlichen vertikal verlaufen und allenfalls < etwa 5° gegenüber der Vertikalen geneigt sein, um einen wirksamen anschließenden reaktiven Ionenätzprozeß zu ermöglichen. Eine mit 18 bezeichnete Schicht wird dann sowohl auf die horizontalen Oberflächenbereiche als auch auf die im wesentlichen vertikalen Oberflächenbereiche aufgebracht. Diese Schicht 18 mag eine Schichtdicke im Bereich von etwa 50 bis 2000 nm aufweisen, wobei die exakte Schichtdicke von der speziellen Ausgestaltung des weiteren Verfahrens und der jeweiligen Anwendung abhängt. Die Schicht 18 kann aus einer Vielzahl von Materialien oder Kombinationen solcher Materialien bestehen, wozu insbesondere Siliciumdioxid, Siliciumnitrid, Aluminiumoxid, polykristallines Silicium und dergleichen gehören.

Die in Fig. 1B dargestellte Struktur steht damit für den Plasma- oder reaktiven Ionenätzschritt bereit. Bezüglich dieses Verfahrensschritts wird ergänzend auf die eingangs angegebene Literatur verwiesen. Vorzugsweise enthält das HF-induzierte Plasma einen reaktiven Chlorbestandteil, vgl. insoweit die oben angegebenen Patentanmeldungen der Erfinder Harvilchuck und Bondur u. a. Die genaue Beschreibung der HF-Glimmentladungsapparatur findet sich ebenfalls in den genannten Patentanmeldungen von Harvilchuck. Die reaktive Ionen- oder Plasmaat-

mosphäre besteht vorzugsweise aus einer Kombination des Chlorbestandteils mit einem Inertgas, z. B. Argon. Bei einer aus einer HF-Spannungsquelle zugeführten Leistung von größenordnungsmäßig etwa 0,1 bis 0,5 W/cm² wird eine ausreichend hohe Leistungsdichte erzeugt, so daß der reaktive Ionenätzvorgang der Isolierschicht mit einer Ätzrate von etwa 0,01 bis 0,5 μm/min erfolgen kann. Das gewünschte Ergebnis der Ätzbehandlung ist in Fig. 1C dargestellt, wobei die früher mit 18 bezeichnete Schicht praktisch vollständig von den horizontalen Oberflächenbereichen 14 entfernt ist. Bezüglich der auf den vertikalen Oberflächenbereichen 16 angeordneten Schicht 18 ist dabei im wesentlichen keine Einwirkung festzustellen. Das Ergebnis besteht somit entsprechend Fig. 1C in einem sehr klein dimensionierten Bereich 18 auf den vertikalen Oberflächenbereichen 16 dieser Struktur, die damit für weitere Halbleiterprozeßschritte zur Verfügung steht, z. B. für die Durchführung von Diffusions- oder Ionenimplantationsschritten, das Aufbringen von Isolier- oder Leitschichten usw.

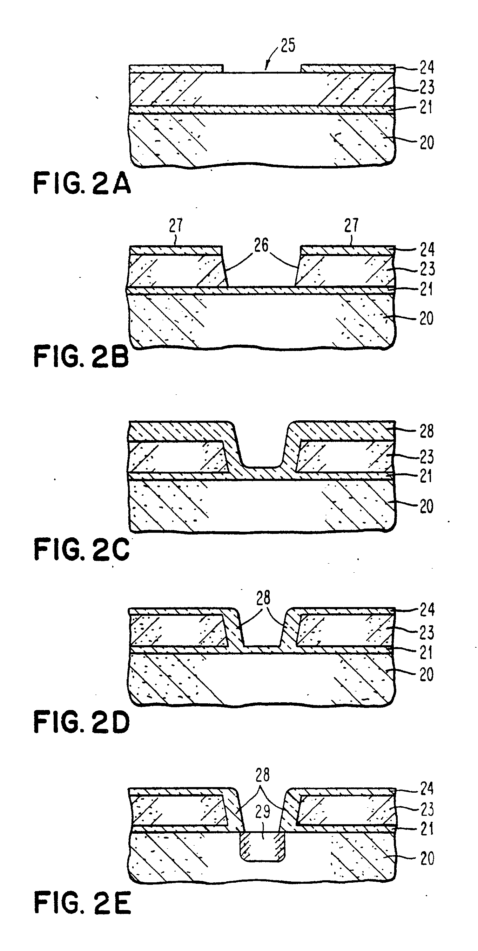

Anhand der Fig. 2A bis 2E soll auf ein zweites Ausführungsbeispiel der Erfindung eingegangen werden, bei dem lithographische Linienbreiten von <1 μm erzielbar sind. Wieder zeigt Fig. 2A in starker Vergrößerung einen kleinen Ausschnitt aus einem Siliciumkörper 20, auf dem eine erste Isolierschicht 21 sowie eine polykristalline Siliciumschicht 23 aufgebracht sind. Die erste Isolierschicht kann dabei aus irgendeinem der bekannten isolierenden Materialien oder einer Kombination daraus bestehen, z. B. aus Siliciumdioxid, Siliciumnitrid, Aluminiumoxid oder dergleichen. Zu den Verfahren zum Aufbringen von Siliciumdioxidschichten zählt beispielsweise das thermische Aufwachsen in einer Sauerstoff- oder Sauerstoff-Wasserdampfatmosphäre bei einer Temperatur von 970°C. Ein zweites Verfahren besteht in einem chemischen Aufdampfen, wobei die Siliciumdioxidschicht aus einer Gasmischung von $SiH_4/O_2$, $SiH_4N_2O$, $SiCl_2H_2/N_2O$ bei einer Temperatur im Bereich von etwa 400 bis 1000°C bei atmosphärischem oder geringerem Druck niedergeschlagen wird. Das Niederschlagen einer Siliciumnitridschicht erfolgt gewöhnlich ebenfalls durch chemisches Aufdampfen bei folgenden Prozeßbedingungen: $SiH_4/NH_3$ bei Temperaturen größer 500°C und Atmosphärendruck oder geringer. Polykristallines Silicium läßt sich in einem chemischen Aufdampfprozeß unter den folgenden Bedingungen niederschlagen: $SiH_4$ bei einer Temperatur im Bereich von 500 bis 1000°C und Atmosphärendruck oder geringer. Eine Maskierungsschicht, z. B. in der Form der mit 24 bezeichneten Siliciumdioxidschicht, wird anschließend auf der Oberfläche der polykristallinen Siliciumschicht 23 gebildet, wobei eines der genannten Verfahren zur thermischen oder chemischen Bildung einer solchen Schicht Einsatz finden kann. Die Dicke dieser Maskierungsschicht aus Siliciumdioxid beträgt in typischen Fällen etwa 200 bis 2000 nm. Mittels standardmäßiger Photolithographie- und Ätzverfahren wird in dieser Siliciumdioxidschicht 24 eine Öffnung 25 mit einer Linienbreite von etwa 2 bis 4 μm gebildet. Die entsprechend Fig. 2A ausgestaltete Struktur wird dann zum Plasmaätzen des polykristallinen Siliciums in eine Prozeßatmosphäre mit den folgenden Eigenschaften eingebracht: $Cl_2$/Ar-Gasmischung, 0,16 W/cm² Leistungsdichte, 10 μm Druck, $SiO_2$-Kathode, 10 cm³/min. Durchflußrate. Dabei wird eine Apparatur der in der eingangs genannten Literatur beschriebenen Art eingesetzt. Der Ätzprozeß ist abgeschlossen, wenn die mit 21 bezeichnete Schicht erreicht ist und die anhand von Fig. 2B gezeigte Struktur vorliegt, bei der ein Graben in der polykristallinen Siliciumschicht 23 geätzt ist. Dieser Graben weist im wesentlichen vertikale Seitenflächen 26 auf. Die ebenfalls vorliegenden horizontalen Oberflächenbereiche sind mit 27 bezeichnet. Anschließend wird sowohl auf die im wesentlichen horizontalen als auch auf die im wesentlichen vertikalen Oberflächenbereiche 27 bzw. 26 eine zweite Isolierschicht 28 aufgebracht, was vorzugsweise durch chemisches Aufdampfen (Niederschlag aus der Gasphase) erfolgt. Auch diese Isolierschicht kann wieder aus einem der bekannten Materialien, wie z. B. Siliciumdioxid, Siliciumnitrid, Aluminiumoxid oder Kombinationen aus diesen Materialien bestehen.

Die entsprechend Fig. 2C ausgestaltete Struktur wird anschließend in eine geeignete Atmosphäre zum reaktiven Ionenätzen der Schicht 28 eingebracht. Die jeweilige Atmosphäre hängt dabei von der jeweiligen Zusammensetzung der Schicht 28 ab. Durch den Ätzprozeß werden im wesentlichen die horizontalen Schichtbereiche der Schicht 28 entfernt und der schmal dimensionierte vertikale Bereich auf dem Siliciumkörper entsprechend Fig. 2D belassen. Die mit 24 bezeichnete Siliciumdioxidschicht bleibt bei diesem Verfahrensschritt im wesentlichen erhalten. Anschließend wird in einem reaktiven Ionenätzschritt unter Verwendung einer geeigneten Ätzatmosphäre die (nun freiliegende) erste Isolierschicht 21 entfernt; die sich daraus ergebende Struktur ist aus Fig. 2E ersichtlich. Als Alternative dazu könnte auch die Schicht 21 durch Fortsetzung des Ätzprozesses für die Schicht 28 entfernt werden. Festzuhalten ist, daß die aus Fig. 2E ersichtliche Öffnung wesentlich kleiner ist als die ursprüngliche Öffnung 25 in Fig. 2A. Durch das geschilderte Verfahren läßt sich somit eine Öffnung mit Abmessungen im Bereich <1 μm bilden, die für anschließende Verfahrensschritte, z. B. Diffusionen, Ionenimplantationen oder als elektrisches Kontaktloch benutzt werden kann. In Fig. 2E ist als eine Anwendungsmöglichkeit ein diffundierter Bereich 29 illustriert.

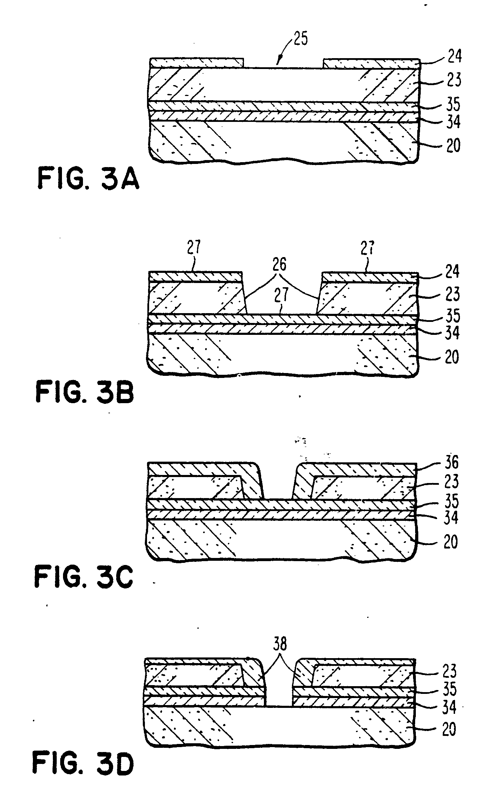

Anhand der Fign. 3A bis 3D soll nun auf ein drittes Ausführungsbeispiel im Rahmen der Erfindung eingegangen werden. Dieses Ausführungsbeispiel weist Ähnlichkeiten zum zweiten Ausführungsbeispiel auf, das anhand der Fign.2A bis 2E erläutert wurde, so daß zum Teil gleiche Bezugszeichen verwendet sind. In diesem Fall ist die erste Isolierschicht aus zwei Schichten zusammengesetzt, nämlich der Siliciumdioxidschicht 34 sowie der Siliciumnitridschicht 35, die in dieser Reihenfolge auf dem Siliciumkörper 20 angeordnet sind. Darüber ist wieder eine polykristalline Siliciumschicht 23 aufgebracht. Eine mit 24 bezeichnete Maskierungsschicht aus Siliciumdioxid ist darauf durch Aufbringen und anschließende Photolithographie- und Ätzbehandlung zur Bildung der mit 25 bezeichneten Öffnung hergestellt. Mittels eines reaktiven Ionenätzschrittes der im Zusammenhang mit dem zweiten Ausführungsbeispiel erläuterten Art wird daraufhin in der Schichtstruktur die aus Fig. 3B ersichtliche Öffnung hergestellt, wobei die resultierende Struktur sowohl horizontale Oberflächenbereiche 27 als auch im wesentlichen vertikale Oberflächenbereiche 26 aufweist. Die der Darstellung in Fig. 3B entsprechende Struktur wird anschließend in einer oxidierenden Atmosphäre, z. B. in Wasserdampf bei 970°C behandelt, wobei auf den Oberflächen der zweiten Isolierschicht eine thermisch gebildete Siliciumdioxidschicht 36 aufwächst. Festzuhalten ist in diesem Zusammenhang, daß bei diesem thermischen Oxidationsprozeß ein Teil der polykristallinen Siliciumschicht 23 verbraucht wird. Anschließend wird wieder ein reaktiver Ionenätzschritt angewandt, um im wesentlichen die horizontalen Siliciumdioxidschichtbereiche 36 zu beseitigen und das mit 38 bezeichnete sehr schmal dimensionierte Gebiet auf dem Siliciumkörper zu definieren. Mittels standardmäßiger Ätzung oder auch mittels eines reaktiven Ionenätzprozesses werden anschließend die dort befindlichen Bereiche der Siliciumdioxidschicht 34 und der Siliciumnitridschicht 35 entfernt. Die aus Fig. 3D ersichtliche resultierende Struktur steht somit zur Verfügung für eine Weiterbehandlung, in der z. B. mittels Diffusion oder Ionenimplantation oder erforderlichenfalls zur Ausbildung eines elektrischen Kontakts Strukturen im Bereich <1 µm ausgebildet werden können.

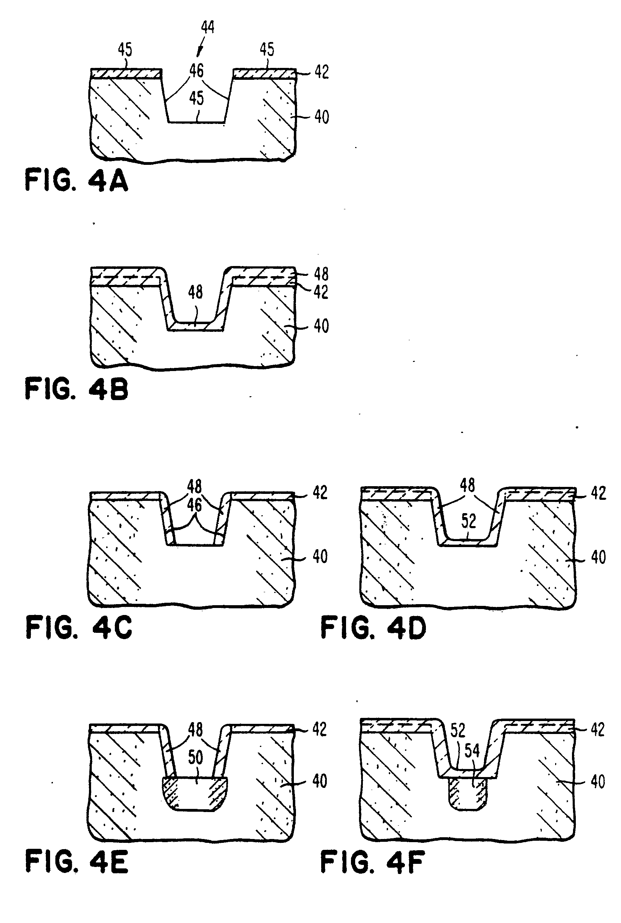

Anhand der Fign. 4A bis 4F soll im folgenden auf ein viertes Ausführungsbeispiel der Erfindung eingegangen werden, wobei in einem Vertiefungsbereich im Siliciumkörper eine Diffusionsmaskierung ausgebildet werden soll, deren Dimensionen unterhalb des µm-Bereichs liegen können. Fig. 4A geht aus von einem Siliciumkörper 40 mit einer auf seiner Oberfläche angeordneten Siliciumdioxid-Maskierungsschicht 42. Die Siliciumdioxidschicht kann durch thermische Verfahren in einer oxidierenden Atmosphäre oder durch chemische Aufdampfverfahren hergestellt sein. Die Maskenöffnung in der Siliciumdioxidschicht 42 ist mittels standardmäßiger Photolithographie- und Ätzverfahren hergestellt. Anschließend ist ein reaktiver Ätzprozeß der oben näher erläuterten Art durchgeführt worden, um die mit 44 bezeichnete Vertiefung im Siliciumkörper zu bilden. Auch bei dieser resultierenden Struktur liegen somit im wesentlichen horizontale Oberflächenbereiche 45 und im wesentlichen vertikale Oberflächenbereiche 46 vor. Auf die in Fig. 4A gezeigte Struktur wird anschließend in einem chemischen Aufdampfprozeß eine Isolierschicht 48 aus einem geeigneten Material, z. B. aus Siliciumdioxid, aufgebracht, woraus die in Fig. 4 dargestellte Struktur resultiert. Die insoweit behandelte Anordnung wird anschließend zur Entfernung der Isolierschicht in eine reaktive Ionenätzatmosphäre eingebracht. Fig. 4C zeigt das Ergebnis eines solchen Prozesses, durch den die Isolierschicht von den horizontalen Oberflächenbereichen entfernt wird. Als Ergebnis verbleibt auf den vertikalen Oberflächen entsprechend Fig. 4C jeweils ein klein dimensionierter Bereich der Isolierschicht 48. Fig. 4E zeigt die resultierende Struktur nach einer thermischen Diffusion von Dotierungsstoffen durch die so hergestellte schmale Öffnung in den Halbleiterkörper hinein, woraus das Diffusionsgebiet 50 resultiert. Sollen die Dotierungsstoffe mittels Ionenimplantation in den Halbleiterkörper eingebracht werden, ist eine Implantation durch eine dünne Isolierschicht vorzuziehen. In diesem Fall läßt man den reaktiven Ionenätzprozeß nur solange andauern, daß eine dünne Schutzschicht 52 entsprechend Fig. 4D verbleibt. Diese Struktur wird anschließend in eine Ionenimplatations-Apparatur eingebracht, in der Ionen durch die Schicht 52 den Dotierungsbereich 54 bilden können.

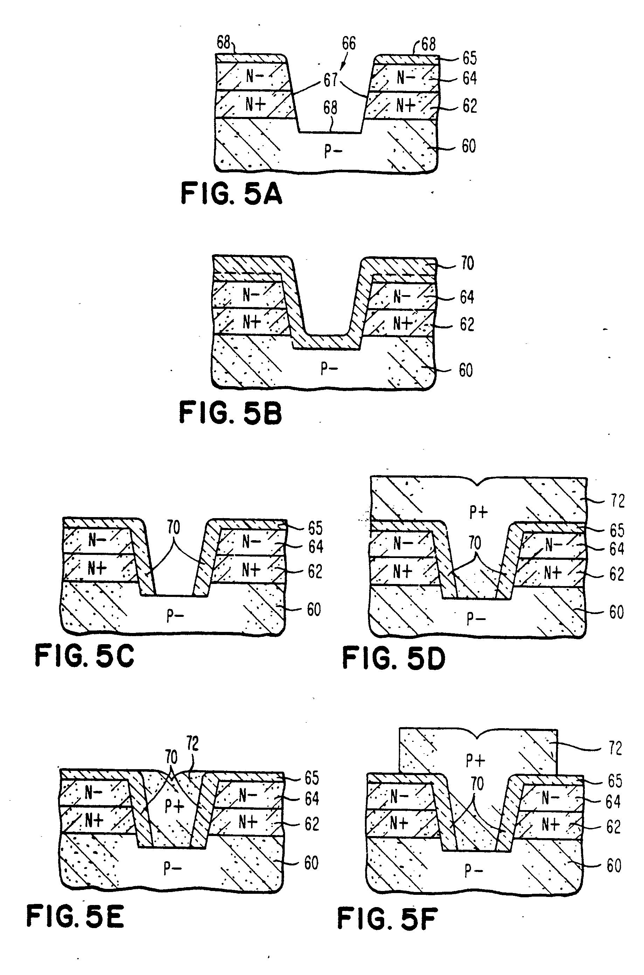

Anhand der Fign. 5A bis 5F soll auf ein fünftes Ausführungsbeispiel der Erfindung eingegangen werden, mit dem ein elektrischer Substratkontakt hergestellt werden kann. In einem P-Substrat aus einkristallinem Silicium 60 ist eine durchgehende N+ Diffusion 62 für einen Subkollektor hergestellt. Darauf ist eine N- Epitaxieschicht 64 gebildet. Diese Prozeßschritte sind übliche Verfahren, die bei der Bildung von beispielsweise NPN-Bipolartransistoren eingesetzt werden. DAs Substrat 60 weist typischerweise eine <100> kristallographische Orientierung des Siliciums sowie einen spezifischen Widerstandswert der Größenordnung von 1 bis 20 $\Omega \cdot$ cm auf. Die Subkollektordiffusion benutzt typisch Arsen mit einer Oberflächenkonzentration von $10^{20} - 10^{21}$ Atomen/cm³, wobei entweder eine Kapseldiffsusion oder eine Ionenimplantation zur Anwendung gelangt. Die Epitaxieschicht 64 läßt man mittels konventioneller Verfahren aufwachsen, z. B. unter Benutzung von $SiCl_4/H_2$- oder $SiH_4/H_2$-Mischungen bei einer Temperatur von etwa 1000 bis 1200°C. Beim Aufwaschen der Epitaxieschicht wandern die in der N+ Schicht befindlichen Dotierungsatome in diese Epitaxieschicht. Die Dicke der Epitaxieschicht beträgt für hochdichte integrierte Schaltungen weniger als etwa 2 µm. Auf der Oberfläche der Epitaxieschicht 64 wird dann thermisch eine Siliciumdioxidschicht 65 gebildet und mittels geeigneter Photolithographie- und Ätzverfahren mit Maskenöffnungen darin versehen. Zur Bildung der in Fig. 5A mit 66 bezeichneten Öffnung wird anschließend ein reaktiver Ionenätzprozeß in einer Atmosphäre aus Cl$_2$ und Ar angewandt. Diese Öffnung erstreckt sich durch das Subkollektorgebiet 62 in das P− Substrat 60. Die so gebildete Vertiefung 66 weist wiederum die mit 67 bezeichneten vertikalen Oberflächenbereiche sowie die mit 68 bezeichneten horizontalen Oberflächenbereiche auf. Über die gesamte Oberfläche der soweit hergestellten Struktur wird anschließend eine durchgehende Isolierschicht 70 aufgebracht, die sowohl die im wesentlichen horizontalen als auch die im wesentlichen vertikalen Oberflächenbereiche bedeckt. Durch einen reaktiven Ionenätzschritt werden von dieser Schicht 70 im wesentlichen die horizontalen Oberflächenbereiche entfernt, wobei auf den vertikalen Oberflächenbereichen entsprechend Fig. 5C diese Schichtbereiche mit kleinen Dimensionen verbleiben. Für die Bildung eines Kontakts zum Substrat 60 wird die so ausgestaltete Vertiefung mit einem leitfähigen Material, z. B. stark P oder N dotiertem polykristallinem Silicium oder einem der zahlreichen bekannten Kontaktmetalle, ausgefüllt. Im Falle von polykristallinem Silicium würde der Dotierungstyp zweckmäßig derselbe sein, wie der des Substrats. Im gezeigten Beispielsfall ist ein P− Substrat 60 vorausgesetzt, so daß in diesem Fall das polykristalline Silicium 72 ebenfalls vom P-Typ wäre. Die in Fig. 5D gezeigte Struktur kann daraufhin weiter behandelt werden, indem man mittels eines Plasmaätzverfahrens das polykristalline Silicium soweit abätzt, daß die in Fig. 5E gezeigte Struktur verbleibt, in der die Vertiefung zur Erzielung einer ebenen Oberfläche ganz mit polykristallinem Silicium 72 ausgefüllt ist. Die Ätzbedingungen für diesen Verfahrensschritt wären ähnlich denen zur Erzeugung der Vertiefung zu Anfang des geschilderten Verfahrensablaufs, d. h. das Ätzen fände in einer Cl$_2$/Ar Atmosphäre statt. Alternativ könnte auch ein standardmäßiger Photolithographie- und Ätzprozeß für die Formgebung des Kontakts entsprechend Fig. 5F angewendet werden.

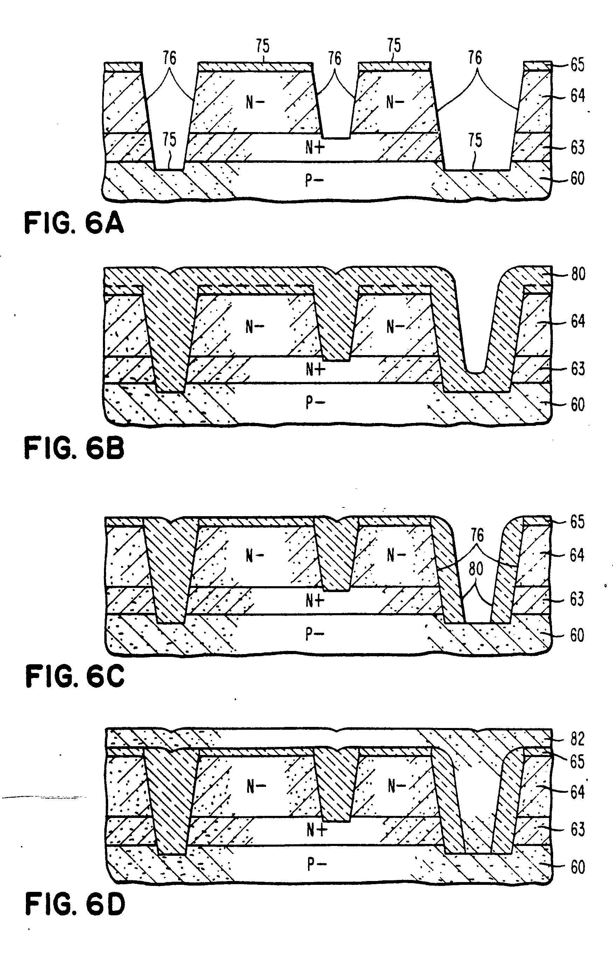

Schließlich soll anhand der Fig. 6A bis 6G auf ein sechstes Ausführungsbeispiel der Erfindung eingegangen werden, bei dem zur gegenseitigen Isolation einkristalliner Bereiche in einem Siliciumkörper entsprechende dielektrische Bereiche, z. B. aus Siliciumdioxid, vorgesehen werden sollen. Der Siliciumkörper wird dazu in einer im Zusammenhang mit den Fign. 5A bis 5F beschriebenen Weise behandelt. Insofern sind gleiche Teile mit denselben Bezugzeichen wie im vorhergehenden Ausführungsbeispiel bzeichnet. Der Siliciumkörper besteht aus einem P− Substrat 60, einem N+ Subkollektorgebiet 63 und einer N− Epitaxieschicht 64. Die Dicke dieser Epitaxieschicht beträgt vorzugsweise weniger als 1,2 µm. Auf die Oberfläche der Epitaxieschicht 64 ist eine isolierende Schicht, z. B. in Form der Siliciumdioxidschicht 65, aufgebracht. Standardmäßige Photolithographie- und Ätzverfahren sind ferner angewendet, um in dieser Siliciumdioxidschicht 65 die gezeigten Öffnungen auszubilden. Das Muster dieser Maskenöffnungen definiert dabei die Lage der dielektrischen Isolationsbereiche, die zur gegenseitigen Isolation der verbleibenden einkristallinen Bereiche sowie des Basis-Emitterbereichs vom Kollektoranschlußbereich dienen sollen. Weiterhin sind einige Öffnungen in diesem Muster größer als andere Öffnungen. Die größeren Öffnungen sind an den später für den elektrischen Kontakt zum Substrat 60 vorgesehenen Stellen angeordnet. Die so ausgebildete Struktur wird einem Plasma- oder reaktiven Ionenätzschritt für Silicium unterworfen, wobei sich entsprechende Vertiefungsmuster mit mindestens zwei unterschiedlichen Breiten im Halbleiterkörper bilden, und wobei erneut im wesentlichen horizontale Oberflächenbereiche 75 sowie im wesentlichen vertikale Oberflächenbereiche 76 verbleiben. Die für die gegenseitige Isolation der einkristallinen Bereiche vorgesehenen Vertiefungen müssen tiefer als das Subkollektorgebiet 62 reichen, während die für die dielektrische Isolation zwischen Basis-Emitterbereich und Kollektoranschlußbereich vorgesehene Vertiefung lediglich teilweise in den Subkollektorbereich 62 hineinreichen sollte. Um diese unterschiedlichen Ätztiefen zu erzielen, wird man zweckmäßig separate Ätzschritte vornehmen, wobei die jeweils anderen Bereiche in geeigneter Weise markiert werden, wie das beispielsweise in der eingangs genannten US-Patentschrift 4 139 442 näher ausgeführt ist. Das Ergebnis des reaktiven Ionenätzens ist die in Fig. 6A dargestellte Anordnung.

Anschließend wird eine mit 80 bezeichnete Isolierschicht auf die Anordnung derart aufgebracht, daß die schmalsten Vertiefungen ausgefüllt werden, wobei die verbleibenden horizontalen sowie (in der Vertiefung mit der größeren Breite verbleibenden) vertikalen Oberflächenbereiche mit einem entsprechenden Überzug versehen werden. Die daraus resultierenden und in Fig. 6B gezeigte Anordnung wird dann einem reaktiven Ionenätzverfahren für diese, beispielsweise aus Siliciumdioxid bestehende Isolierschicht unterworfen. Als Ergebnis werden die horizontalen Oberflächenbereiche weitgehend entfernt und in den Vertiefungen mit der größeren Breite die (in Fig. 6C mit 80 bezeichnete) Beschichtung der im wesentlichen vertikalen Oberflächenbereiche erhalten. Dabei ist festzuhalten, daß die Bodenfläche der Vertiefung mit der größten Breite in einem (sehr klein dimensionierten) Teilbereich als Folge des Ätzverfahrens von jeglicher Isolierschicht freigelegt ist.

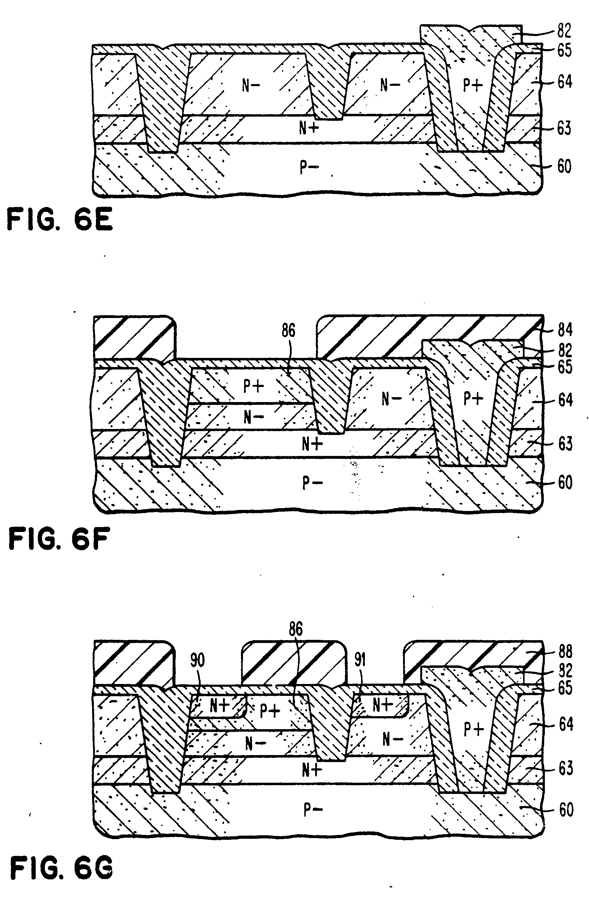

Zur Herstellung eines elektrischen Anschlusses für das P− Substrat 60 wird anschließend eine leitfähige Schicht 82 über die soweit behandelte Anordnung unter Einschluß des freigelegten Siliciumkörpers in der Vertiefung mit den weitesten Abmessungen aufgebracht. Mittels standardmäßig ausgestalteter Photolithographie- und Ätzverfahren erfolgt schließlich die endgültige Formgebung des Anschlusses 82, vgl. Fig. 6G. In Fig. 6F ist die Anwendung einer Grobmaskierung 84 aus Photolack dargestellt, wodurch die Bereiche außerhalb des Basisbereiches für den herzustellenden NPN-Transistor abgedeckt werden. Das P+ Basisgebiet 86 wird mit einer üblichen Ionenimplantation gebildet. Die Photolackmaske 84 wird dann entfernt und eine weitere Photolackmasse 88 in gleicher Weise ausgebildet, die alle Bereiche außerhalb des Emitterbereichs sowie außerhalb des Kollektoranschlußbereichs abdeckt. Mittels einer Ionenimplantation werden in den so freiliegenden Bereichen das N+ Emittergebiet 90 im Basisgebiet 86 sowie das Kollektoranschlußgebiet 91 erzeugt. Elektrische Anschlüsse zu den Transistorzonen können schließlich in konventioneller Weise durch Niederschlags- sowie Lithographie- und ätzverfahren vorgesehen werden, worauf im Rahmen dieser Erfindung nicht mehr näher eingegangen zu werden braucht.

## Patentansprüche

1. Verfahren zur Herstellung einer Halbleiteranordnung, bei dem mindestens eine Maskenöffnung auf der Oberfläche eines die Halbleiteranordnung enthaltenden Körpers (10) ausgebildet wird, dadurch gekennzeichnet, daß zunächst in dem Material des Körpers (10) mittels an sich bekannter Formgebungsverfahren vorgegebene Öffnungsweiten aufweisende Ausnehmungen mit im wesentlichen horizontalen (14) sowie mit im wesentlichen vertikalen (16) Oberflächen hergestellt werden (z. B. Fig. 1A), daß darauf eine diese im wesentlichen horizontalen sowie im wesentlichen vertikalen Oberflächen der Ausnehmungen bedeckende Maskierungsschicht (18) aufgebracht wird (z. B. Fig. 1B), und daß diese Maskierungsschicht schließlich einem reaktiven Ionenätzverfahren derart unterzogen wird, daß in erster Linie die Maskierungsschicht von den horizontalen Oberflächen der Ausnehmungen abgetragen wird und die auf den vertikalen Oberflächen der Ausnehmungen verbleibenden Bereiche der Maskierungsschicht zur Definition der mindestens einen Maskenöffnung mit gegenüber der Ausnehmung geringerer Öffnungsweite belassen werden (z. B. Fig. 1C).

2. Verfahren nach Anspruch 1, dadurch gekennzeichnet, daß es sich bei dem Formgebungsverfahren des Körpers (10) um reaktives Ionenätzen handelt.

3. Verfahren nach Anspruch 1 oder 2, dadurch gekennzeichnet, daß die Maskierungsschicht (18) eine Isolierschicht ist, die innerhalb der Maskenöffnung von der horizontalen Oberfläche der Ausnhemung vollständig entfernt wird, worauf durch die derart freigelegte Öffnung mittels Diffusion ein Dotierungsgebiet (z. B. 29 in Fig. 2E) in den Körper eingebracht wird.

4. Verfahren nach Anspruch 1 oder 2, dadurch gekennzeichnet, daß die Maskierungsschicht eine Isolierschicht ist, die innerhalb der Maskenöffnung von der horizontalen Oberfläche der Ausnehmung bis auf eine dünne Schutzschicht (z. B. 52 in Fig. 4D) entfernt wird, worauf dort mittels Implantation ein Dotierungsgebiet (z. B. 54 in Fig. 4F) in den Körper eingebracht wird.

5. Verfahren nach Anspruch 1 oder 2, dadurch gekennzeichnet, daß die Maskierungsschicht eine Isolierschicht ist und in mindestens einer Maskenöffnung eine elektrisch leitfähige Schicht (z. B. 72 in Fig. 5D) aufgebracht wird.

6. Verfahren nach einem der vorhergehenden Ansprüche, dadurch gekennzeichnet, daß die Dicke der Maskierungsschicht (z. B. 18 in Fig. 1, 28 in Fig. 2, etc.) etwa 50 bis 2000 nm beträgt.

7. Verfahren nach einem der vorhergehenden Ansprüche, dadurch gekennzeichnet, daß die Maskierungsschicht (z. B. 18 in Fig. 1, 28 in Fig. 2, etc.) aus vorzugsweise chemisch niedergeschlagenem Siliciumdioxid besteht.

8. Verfahren nach einem der vorhergehenden Ansprüche, dadurch gekennzeichnet, daß die Neigung der im wesentlichen vertikalen Oberflächen (16) der Ausnehmungen bis maximal 5° gegenüber der Vertikalen beträgt.

9. Verfahren nach einem der vorhergehenden Ansprüche, dadurch gekennzeichnet, daß es sich bei dem Körper um ein Siliciumsubstrat handelt.

10. Verfahren nach mindestens einem der Ansprüche 1 bis 8, dadurch gekennzeichnet, daß es sich bei dem Körper um eine Schichtstruktur handelt, bei der auf einem Siliciumsubstrat (20) eine Isolierschicht (21) und darauf eine Schicht (23) aus polykristallinem Silicium angeordnet sind, wobei mittels reaktivem Ionenätzen mindestens an einer Stelle die Schicht aus polykristallinem Silicium abgetragen ist.

11. Verfahren nach Anspruch 10, dadurch gekennzeichnet, daß die Isolierschicht (21) aus Siliciumdioxid besteht.

12. Verfahren nach Anspruch 10, dadurch gekennzeichnet, daß die Isolierschicht als Siliciumdioxid/Siliciumnitrid-Doppelschicht (34, 35) gebildet ist.

13. Verfahren nach mindestens einem der Ansprüche 1 bis 9, dadurch gekennzeichnet, daß zur Herstellung einer Halbleiteranordnung mit dielektrischen Isolationsbereichen (Fig. 6) mittels reaktivem Ionenätzen in dem Körper Ausnehmungen mit mindestens zwei unterschiedlichen Öffnungsbreiten geätzt werden, welche die verbleibenden einkristallinen Bereiche des Körpers voneinander trennen, daß darauf die Maskierungsschicht (80) so aufgebracht wird, daß dadurch die schmaleren der unterschiedlich breiten Ausnehmungen vollständig aufgefüllt werden, und daß in der oder den breiteren Ausnehmungen die mindestens eine Maskenöffnung hergestellt wird, wobei innerhalb der Maskenöffnung(en) die Maskierungsschicht von der horizontalen Oberfläche der Ausnhemung(en) vollständig entfernt wird, worauf in der Maskenöffnung eine elektrisch leitfähige Schicht (82) vorgesehen wird.

14. Verfahren nach Anspruch 13, dadurch gekennzeichnet, daß zur Herstellung einer in Bipolartechnologie ausgeführten Halbleiteranordnung von einem Silicium-Körper mit einem vergrabenen Subkollektorbereich (z. B. 63 in Fig. 6) ausgegangen wird und die Ausnehmungen sich zum Teil bis unter den Subkollektorbereich erstreckend ausgebildet werden.

## Claims

1. Method of producing a semiconductor device wherein at least one mask opening is formed on the surface of a body (10) comprising the semiconductor device, characterized in the recesses with predetermined aperture widths and substantially horizontal (14) and substantially vertical (16) surfaces are initially formed in the material of the body (10), using forming processes known per se (e. g., Fig. 1A), that subsequently a masking layer (18) is apllied covering these substantially horizontal and substantially vertical surfaces of the recesses (e. g., Fig. 1B), and that this masking layer is finally subjected to reactive ion etching such that the masking layer is substantially removed from the horizontal surfaces of the recesses, and the regions of the masking layer remaining on the vertical surfaces of the recesses are used to define at least one mask opening with a smaller aperture width than the recess (e. g., Fig. 1C).

2. Method according to claim 1, characterized in that reactive ion etching is used as a forming process for the body (10).

3. Method according to claim 1 or 2, characterized in that the masking layer (18) is an insulating layer which inside the mask opening is completely removed from the surface of the recess, an impurity (e. g., 29 in Fig. 2E) being subsequently diffused through the opening thus bared into the body.

4. Method according to claim 1 or 2, characterized in that the masking layer is an insulating layer which inside the mask opening is removed from the horizontal surface of the recess except for a thin screen layer (e. g., 52 in Fig. 4D), an impurity (e. g., 54 in Fig. 4F) being subsequently implanted through this layer into the body.

5. Method according to claim 1 or 2, characterized in that the masking layer is an insulating layer, and an electrically conductive layer (e. g., 72 in Fig. 5D) is apllied in at least one mask opening.

6. Method according to any one of the preceding claims, characterized in that the thickness of the masking layer (e. g., 18 in Fig. 1, 28 in Fig. 2, etc.) is about 50 to 2000 nm.

7. Method according to any one of the preceding claims, characterized in that the masking layer (e. g., 18 in Fig. 1, 28 in Fig. 2, etc.) is preferably chemically vapor deposited silicon dioxide.

8. Method according to any one of the preceding claims, characterized in that the substantially vertical surfaces (16) of the recesses are inclined up to a maximum of 5° to the vertical.

9. Method according to any one of the preceding claims, characterized in that the body is a silicon substrate.

10. Method according to at least one of the claims 1 to 8, characterized in that the body is a composite structure, wherein the silicon substrate (20) is covered by an insulating layer (21) followed by a layer (23) of polycrystalline silicon, wherein the layer of polycrystalline silicon is removed by reactive ion etching et least in one region.

11. Method according to claim 10, characterized in that the insulating layer (21) is silicon dioxide.

12. Method according to claim 10, characterized in that the insulating layer is a composite layer of silicon dioxide and silicon nitride (34, 35).

13. Method according to at least one of the claims 1 to 9, characterized in that for producing a semiconductor device with dielectric isolation regions (Fig. 6), recesses with at least two different aperture widths are reactively ion etched into the body, these recesses separating the remaining monocrystalline regions of the body from each other, that subsequently the masking layer (80) is apllied in such a manner that the narrower of the differently wide recesses is filled completely, and that in the wider recess(es) remaining at least one mask opening is formed, completely removing the masking layer form the horizontal surface of the recess(es) in the mask opening(s), ans subsequently providing an electrically conductive layer (82) in the mask opening.

14. Method according to claim 12, characterized in that for producing a semiconductor device in bipolar technology, a silicon body with a buried sucollector region (e. g., 63 in Fig. 6) is used, and the recesses extend partially into the subcollector region.

## Revendications

1. Procédé pour fabriquer und dispositif semi-conducteur, dans lequel on forme au moins une ouverture de masque sur la surface d'un corps (10) comportant le dispositif semi-conducteur, caractérisé en ce qu'on utilise des procédés de mise en forme connus pour réaliser dans le matériau du corps (10) des évidements à largeur d'ouverture prédéterminée et ayant des surfaces essentiellement horizontales (14) et essentiellement verticales (16) (par exemple la figure 1A), en ce qu'on dépose une couche de masquage (18) recouvrant lesdites surfaces essentiellement horizontales et essentiellement verticales des évidements (par exemple la figure 1B), et en ce qu'on soumet enfin cette couche de masquage à un procédé de décapage par ions réactifs de telle sorte qu'on enlève d'abord la couche de masquage des surfaces horizontales des évidements et qu'on laisse les régions de la couche de masquage restant sur les surfaces verticales des évidements pour définir au moins une ouverture de masque ayant une largeur d'ouverture inférieure à l'évidement (par exemple la figure 1C).

2. Procédé selon la revendication 1, caractérisé en ce que le procédé de mise en forme du corps (18) est un procédé de décapage par ions réactifs.

3. Procédé selon la revendication 1 ou 2, caractérisé en ce que la couche de masquage (18) est une couche isolante qu'on enlève à l'intérieur de l'ouverture de masque complètement de la surface horizontale de l'évidement et en ce qu'on forme, par diffusion à travers l'ouverture ainsi exposée, une région de dopage (par exemple 29 de la figure 2E) dans ledit corps.

4. Procédé selon la revendication 1 ou 2, caractérisé en ce que la couche de masquage est une couche isolante qu'on enlève à l'intérieur de l'ouverture de masque de la surface horizontale de l'évidement à l'exception d'une couche de protection mince (par exemple 52 de la figure 4D) à travers laquelle on diffuse par implantation une région de dopage (par exemple 54 de la figure 4F) dans ledit corps.

5. Procédé selon la revendication 1 ou 2, caractérisé en ce que la couche de masquage est une couche isolante et en ce qu'on dépose dans au moins une ouverture de masque une couche électriquement conductrice (par exemple 72 de la figure 5D).

6. Procédé selon l'une quelconque des revendications précédentes, caractérisé en ce que l'épaisseur de la couche de masquage (par exemple 18 de la figure 1, 28 de la figure 2, etc.) est comprise entre environ 50 et 2000 nm.

7. Procédé selon l'une quelconque des revendications précédentes, caractérisé en ce que la couche de masquage (par exemple 18 de la figure 1, 28 de la figure 2, etc.) est de préférence composée d'un dioxyde de silicium obtenu par dépôt chimique.

8. Procédé selon l'une quelconque des revendications précédentes, caractérisé en ce que l'inclinaison des surfaces essentiellement verticales (16) des évidements est de 5° au maximum par rapport à la verticale.

9. Procédé selon l'une quelconque des revendications précédentes, caractérisé en ce que le corps est un substrat en silicium.

10. Procédé selon l'une quelconque des revendications 1 à 8, caractérisé en ce que le corps est une structure à couches, dans laquelle sont déposées, sur un substrat de silicium (20), une couche isolante (21) et sur celle-ci une couche de silicium polycristallin (23), cette couche de silicium polycristallin étant enlevée à moins un endroit à l'aide d'un décapage par ions réactifs.

11. Procédé selon la revendication 10, caractérisé en ce que la couche isolante (21) est composée de dioxyde de silicium.

12. Procédé selon la revendication 10, caractérisé en ce que la couche isolante forme une couche double de dioxyde de silicium/nitrure de silicium (34, 35).

13. Procédé selon l'une quelconque des revendications 1 à 9, caractérisé en ce que, dans la fabrication d'un dispositif semi-conducteur ayant des régions isolantes diélectriques (figure 6) on utilise le décapage par ions réactifs pour décaper dans le corps des évidements ayant au moins deux largeurs d'ouverture différentes qui séparent les régions monocristallines restantes du corps les unes des autres, en ce qu'on y dépose ensuite la couche de masquage (80) de telle sorte que les plus étroits des évidements à largeurs différentes sont complétement remplis, et en ce qu'on forme au moins une ouverture de masque dans l'évidement (ou les évidements) plus large, la couche de masquage étant complétement enlevée de la surface horizontale de l'évidement (ou des évidements) à l'intérieur de l'ouverture ou des ouvertures de masque de la couche de masquage, et en ce qu'on dépose enfin une couche électriquement conductrice (82) dans l'ouverture de masque.

14. Procédé selon la revendication 13, caractérisé en ce qu'on utilise un corps de silicium ayant une région de sous-collecteur enterrée (par exemple 63 de la figure 6) pour fabriquer un dispositif semi-conducteur dans la technique bipolaire, les évidements s'étendant en partie jusqu'en dessous de la région de sous-collecteur.

FIG. 1A

FIG. 1B

FIG. 1C

0 010 596

FIG. 2A

FIG. 2B

FIG. 2C

FIG. 2D

FIG. 2E

**FIG. 3A**

**FIG. 3B**

**FIG. 3C**

**FIG. 3D**

FIG. 4A

FIG. 4B

FIG. 4C

FIG. 4D

FIG. 4E

FIG. 4F

FIG. 5A

FIG. 5B

FIG. 5C

FIG. 5D

FIG. 5E

FIG. 5F

FIG. 6A

FIG. 6B

FIG. 6C

FIG. 6D

FIG. 6E

82
65
64
63
60

FIG. 6F

84
82
65
64
63
60

86

FIG. 6G

88
82
65
64
63
60

86
90    91